## Europäisches Patentamt

## European Patent Office

## Office européen des brevets

(11) Publication number: **0 168 859**
**B1**

# EUROPEAN PATENT SPECIFICATION

(45) Date of publication of patent specification: **19.04.89**

(21) Application number: **85200937.2**

(22) Date of filing: **14.06.85**

(51) Int. Cl.⁴: **H 05 K 7/20**

(54) Heat dissipation device for an electrical component.

(30) Priority: **18.06.84 NL 8401921**

(43) Date of publication of application:
**22.01.86 Bulletin 86/04**

(45) Publication of the grant of the patent:
**19.04.89 Bulletin 89/16**

(84) Designated Contracting States:
**BE DE FR GB IT NL SE**

(56) References cited:
**DE-A-2 336 878**
**US-A-3 129 282**

**IBM TECHNICAL DISCLOSURE BULLETIN, vol. 19, no. 5, October 1976, page 1802, New York, US; O.J. CAIN et al.: "Semiconductor module with improved air cooling"**

**IBM TECHNICAL DISCOSURE BULLETIN, vol. 19, no. 7, December 1976, page 2652, New York, US; J.H. CIANCANELLI: "Circuit module with heat transfer"**

(73) Proprietor: **N.V. Philips' Gloeilampenfabrieken**
**Groenewoudseweg 1**
**NL-5621 BA Eindhoven (NL)**

(72) Inventor: **Veerman, Frederik Wilhelm Johan**
**c/o INT. OCTROOIBUREAU B.V. Prof. Holstlaan 6**
**NL-5656 AA Eindhoven (NL)**

(74) Representative: **Cuppens, Hubertus Martinus Maria et al**
**INTERNATIONAAL OCTROOIBUREAU B.V. Prof. Holstlaan 6**
**NL-5656 AA Eindhoven (NL)**

Courier Press, Leamington Spa, England.

## Description

The invention relates to a heat dissipation device comprising a heat conductor arranged between a heat-producing electrical component and a heat exchanger, the heat conductor being in heat-conducting contact both near its one end and near its other end by clamping with the electrical component and the heat exchanger, respectively.

In a known heat dissipation device of the kind mentioned in the opening paragraph (see German Patent Specification 3212592), the heat conductor comprises a ribbon cable of twisted copper wire, which is clamped near its both ends in U-shaped holders, which are in heat-conducting contact with the electrical component and the heat exchanger, respectively. The holders are clamped on the ribbon cable by means of local indentations in the material of one of the limbs of the two holders.

A disadvantage of the known heat dissipation device is that due to the local deformations of the holders an optimum heat transfer is guaranteed only at the area of the deformations. In the region between the deformations, the contact pressure between the holder and the ribbon cable is smaller than at the area of the deformations or it is even substantially absent. Moreover, so-called cold flow occurs at the area of the deformations, which results in that the contact pressure becomes smaller especially after a number of temperature variations.

The invention has for its object to provide a heat dissipation device, in which the said disadvantage is avoided.

The invention is for this purpose characterized in that the heat conductor comprises at least one cable with a bundle of cable cores of heat-conducting material, which is inserted near its one end into a cylindrical hole of a heat-conducting holder and is inserted near its other end into a further cylindrical hole of the heat exchanger, the bundle of cable cores being in heat-conducting contact on all sides near its both ends with the walls of the respective holes in the holder and in the heat exchanger by means of rotation-symmetrical pressure contact of a pointed pin inserted centrically into the bundle of cable cores.

It should be noted that British Patent Specification 1380351 discloses an electrical connection, in which a pin is in electrical pressure contact with the cable cores of a connection cable. In this case, the pressure contact is obtained by the elasticity of a cable sheath and resilient clamping means.

A particular embodiment of the invention, by which a rotation-symmetrical pressure contact is obtained in a simple manner, is further characterized in that the cylindrical hole communicates with a coaxial centering hole, which has a diameter which is smaller than that of the cylindrical hole.

The invention will be described more fully with reference to the drawing, in which:

Fig, 1 is a longitudinal sectional view of the heat dissipation device,

Fig. 2 is a partial cross-sectional view taken on the line II-II in Fig. 1 on an enlarged scale,

Fig. 3 is a plan view of a part of the heat dissipation device shown in Fig. 1.

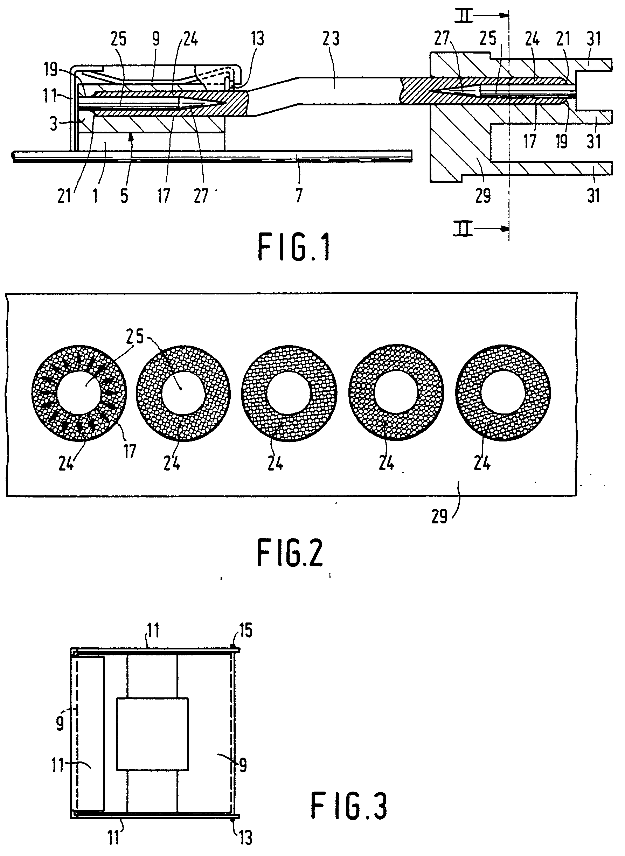

The heat dissipation device shown in Fig. 1 for an electrical component 1 comprises a holder 3, which is preferably made of aluminium and engages under pressure contact a heat-emitting surface 5 of the electrical component 1, which is secured to a substrate 7. In the present case, the holder 3 consists of a rectangular block of aluminium. The holder 3 is pressed against the surface 5 by means of a clamping spring 9, which consists of an alloy of copper, nickel and zinc (new silver) and is hooked into a U-shaped metal sheath 11 (see Fig. 3) by means of vanes 13 and 15. The metal sheath 11 is also made of an alloy of copper, nickel and zinc (new silver). The holder 3 is provided with five cylindrical holes 17 which communicate coaxially with centering holes 19. The diameter of the holes 17 is larger than the diameter of the centering holes 19 so that a shoulder 21 is formed at the area of the transition from a hole 17 to a centering hole 19. Into each of the five holes 17 is inserted a flexible cable 23 which engages with its end the shoulder 21. The cable 23 comprises a number of twisted cable cores 24 of heat-conducting material, such as, for example, tinplated copper. A metal pin 25 with a pointed end 27 is inserted into the bundle of cable cores of each cable 23. The pin 25 is made, for example, of stainless steel. Since the diameter of the — for the major part cylindrical - pin 25 is smaller than the diameter of the hole 17, the cable cores 24 are pressed on all sides rotation-symmetrically against the wall of the hole 17. The pin 25 consequently spreads the cable cores 24. A deformation of the holder 3 does not occur due to the fact that the latter is comparatively rigid. The pin 25 is substantially not deformed either. Any cold flow of the cable cores 24 does not lead to a decrease of the pressure force because the cable cores 24 are enclosed on all sides between the comparatively rigid holder 3 and the comparatively rigid pin 25. The diameter of the centering hole 19 is equal to the diameter of the cylindrical part of the pin 25 so that upon insertion the latter penetrates centrically into the cable 23 and establishes therewith a rotation-symmetrical pressure contact which guarantees an optimum heat transfer from the surface 5 to the cable 23. The length of the hole 17 and the length of the pin 25 are chosen in correspondence with the required heat-transferring surface area.

The cable 23 is inserted near its end remote from the holder 3 into a cylindrical hole 17 of a heat exchanger 29. This of course also applies to the four remaining cables 23. The heat exchanger 29, which is preferably made of aluminium, has cooling fins 31, which give off heat to the ambient air by radiation and by convection. The cables 23 are secured in the heat exchanger 29 in the same manner in which the cables 23 are secured in the holder 3. Therefore, corresponding reference numerals are used. The heat exchanger 29 is preferably mounted on a heat-conducting part of the apparatus, which is in thermal contact with the ambient air.

The electrical component 1 may be a single electrical component, but may also be an integrated electric circuit. The component must always be provided with a heat-conducting part which is in thermal contact with the holder 3. Although preferably flat surfaces at the component and the holder are used for the heat transfer, of course a profiled surface having a comparatively large heat-transferring surface area may also be used. Use may be made, for example, of mating crenelations of the component and the holder.

It should be noted that the flexibility of the cables 23 permits a different level of the holes 17 in the holder 3 and the holes 17 in the heat exchanger 29 with respect to the substrate 7. Consequently, electrical components of different height can be mounted in the region on the substrate 7 located between the holder 3 and the heat exchanger 29 without the cables 23 causing trouble.

## Claims

1. A heat dissipation device comprising a heat conductor arranged between a heat-producing electrical component and a heat exchanger, the heat conductor being in heat-conducting contact both near its one end and near its other end by clamping with the electrical component and the heat exchanger, respectively, characterized in that the heat conductor comprises at least one cable with a bundle of cable cores of heat-conducting material, which is inserted near its one end into a cylindrical hole of a heat-conducting holder and is inserted near its other end into a further cylindrical hole of the heat exchanger, the bundle of cable cores being in heat-conducting contact on all sides near its both ends with the walls of the respective holes in the holder and in the heat exchanger by means of rotation-symmetrical pressure contact of a pointed pin inserted centrically into the bundle of cable cores.

2. A heat dissipation device as claimed in Claim 1, characterized in that the cylindrical hole communicates with a coaxial centering hole, which has a diameter which is smaller than that of the cylindrical hole.

3. A heat dissipation device as claimed in Claim 1, characterized in that the heat-conducting holder is in pressure contact with an electrical component secured on a substrate by means of a clamping spring which is hooked into a sheath arranged on the substrate.

4. A heat dissipation device as claimed in Claim 1, characterized in that the holder and the heat exchanger are made of aluminium, while the cable cores and the pins are made of tin-plated copper and stainless steel, respectively.

## Patentansprüche

1. Wärmeableiteinrichtung mit einem Wärmeleiter zwischen einem wärmeerzeugenden elektrischen Baustein und einem Wärmeaustauscher, wobei der Wärmeleiter sowohl bei seinem einen Ende als auch bei seinem anderen Ende durch Anklammerung am elektrischen Baustein bzw. am Wärmeaustauscher in Wärmeleitkontakt ist, dadurch gekennzeichnet, daß der Wärmeleiter wenigstens ein Kabel mit einem Bündel von Kabelkernen aus wärmeleitendem Material enthält, wobei das Bündel mit seinem einen Ende in ein zylindrisches Loch einer Wärmeleithalterung und bei seinem anderen Ende in ein weiteres zylindrisches Loch des Wärmeaustauschers eingesteckt ist, wobei das Kabelkernbündel an allen Seiten nahe bei seinen beiden Enden in Wärmeleitkontakt ist mit den Wänden der betreffenden Löcher in der Halterung und im Wärmeaustauscher mittels eines rotationssymmetrischen Druckkontakts eines spitzen Stiftes, der in das Kabelkernbündel zentrisch eingeführt ist.

2. Wärmeableiteinrichtung nach Anspruch 1, dadurch gekennzeichnet, daß das zylindrische Loch mit einem koaxialen Zentrierloch in Verbindung steht, dessen Durchmesser kleiner als der des zylindrischen Lochs ist.

3. Wärmeableiteinrichtung nach Anspruch 1, dadurch gekennzeichnet, daß die Wärmeleithalterung in Druckkontakt steht mit einem elektrischen Baustein, der mittels einer Klemmfeder auf einem Substrat befestigt ist, und diese Feder ist in einen auf dem Substrat angebrachten Mantel eingehakt.

4. Wärmeableiteinrichtung nach Anspruch 1, dadurch gekennzeichnet, daß die Halterung und der Wärmeaustauscher aus Aluminium, aber die Kabelkerne und die Stifte aus zinnüberzogenem Kupfer bzw. aus rostfreiem Stahl hergestellt sind.

## Revendications

1. Dispositif de dissipation de chaleur comprenant un conducteur de chaleur disposé entre un composant électrique produisant de la chaleur et un échangeur de chaleur, le conducteur de chaleur étant en contact de conduction thermique, près de sa première extrémité et près de son autre extrémité, par serrage dans le composant électrique et dans l'échangeur de chaleur, respectivement, caractérisé en ce que le conducteur de chaleur comprend au moins un câble comportant un faisceau d'âmes de câble en matière conductrice de la chaleur, qui est enfoncé près de sa première extrémité, dans un trou cylindrique d'un support conducteur de chaleur et près de son autre extrémité dans un autre trou cylindrique de l'échangeur de chaleur, le faisceau d'âmes de câble étant en contact de conduction thermique de tous côtés près de ses deux extrémités, avec les parois des trous respectifs du support et de l'échangeur de chaleur au moyen d'un contact sous pression à symétrie de rotation d'une broche pointue enfoncée dans le centre du faisceau d'âmes de câble.

2. Dispositif de dissipation de chaleur suivant la revendication 1, caractérisé en ce que le trou cylindrique communique avec un trou de centrage coaxial qui a un diamètre inférieur à celui du trou cylindrique.

3. Dispositif de dissipation de chaleur suivant la revendication 1, caractérisé en ce que le support conducteur de chaleur est en contact sous pression avec un composant électrique fixé sur un substrat au moyen d'un ressort de serrage qui est ancré dans un entourage disposé sur le substrat.

4. Dispositif de dissipation de chaleur suivant la revendication 1, caractérisé en ce que le support et l'échangeur de chaleur sont en aluminium, tandis que les âmes de câble et les broches sont en cuivre étamé et en acier inoxydable, respectivement.

FIG.1

FIG.2

FIG.3